# EUROPEAN PATENT APPLICATION

(11) **EP 2 600 703 A1**
(43) Date of publication of application: **05.06.2013**
(21) Application number: 11812334.8
(22) Date of filing: 20.07.2011
(51) Int. Cl.: H05K 3/46

(54) **SUBSTRATE STRUCTURE FOR VEHICLE-MOUNTING ELECTRONIC DEVICE**

(30) Priority: 30.07.2010 JP 2010171312
(71) Applicant: Hitachi Automotive Systems, Ltd., Hitachinaka-shi Ibaraki 312-8503 (JP)
(72) Inventor: ABE Hiroyuki, Hitachinaka-shi Ibaraki 312-8503 (JP); SHIBATA Mizuki, Hitachinaka-shi Ibaraki 312-8503 (JP)
(74) Representative: MERH-IP Matias Erny Reichl Hoffmann
(86) International application number: PCT/JP2011/066432
(87) International publication number: WO 2012/014743

(57) **Abstract**

Provided is a highly reliable ceramic circuit board which can be manufactured at a low cost and is friendly to environment as a material from which lead is eliminated in forming the multilayered structure.

A multi-layered ceramic circuit board includes: a sintered ceramic base body 2; a first circuit wiring pattern 3 which is formed on a surface of the ceramic base body and is formed of conductive paste made of conductive metal; an insulation layer 8 which is formed on a surface layer of the first circuit wiring pattern and is made of a dielectric; and a conductive pattern and a resistor 4 which are formed on a surface layer of the insulation layer, the conductive pattern having a second circuit wiring pattern and a land on which a circuit mounting part is mounted are formed, wherein the portions other than the land portion on which the circuit mounting part is mounted are covered with a protective film 5 by coating, and an electronic circuit part 7 is connected to the land by a conductive adhesive agent, wherein the dielectric is formed of a green sheet 11 of a low temperature co-fired ceramics circuit board which is prepared by mixing alumina powder and glass powder with a solvent (see Fig. 5).

## Description

### Technical Field

The present invention relates to a vehicle-mounted electronic device. Particularly, the present invention relates to a circuit board structure for various sensors which output various physical quantities as electric signals using sensing elements for detecting various physical quantities and an electronic circuit for controlling the sensing elements which are arranged in the inside of an engine room and around an exhaust system, and a circuit board structure for a control unit having a microprocessor arithmetic operation machine which controls various states of the vehicle upon receiving electric signals from the various sensors.

### Background Art

Recently, from a viewpoint of preservation of environment, the regulation for the use of lead, cadmium, hexavalent chromium and the like has started, and the substitution of solder and terminals made of metal which are used in electronic devices with a material which contains no lead has been accelerated. However, currently, the elimination of lead contained in glass is technically difficult so that lead contained in glass is not subjected to regulations also under international standards in this field which determine the respective regulations.

However, recently, the movement for regulating also lead contained in glass has been started to be taken up for discussion in various organizations.

What is particularly problematic is that in a ceramic hybrid circuit board where circuits are formed on a ceramic substrate such that a conductive pattern, resistors and dielectrics are formed on the ceramic substrate by printing, and these printed components are baked (hereinafter referred to as a circuit board), glass is mixed into all paste materials which are used as materials for forming circuits other than the material for forming the ceramic substrate. A glass component and a solvent are mixed into the conductive material pattern besides silver, copper, alloy materials of silver and palladium or the like, a glass component and a solvent are mixed into the resistors besides ruthenium oxide which becomes a material for forming resistors, and the dielectrics are a glass material per se.

To explain the current situation, with respect to the above-mentioned conductive paste and resistor paste, products into which lead is mixed appear on the market currently, and the further improvement of the products is expected.

What is problematic is a glass paste for dielectrics. Currently, with respect to the dielectric paste, products from which lead is eliminated are few, and the products from which lead is eliminated exhibit a poor dielectric property and poor productivity so that the products from which lead is eliminated are not largely adopted in this field currently. According to the reason the products from which lead is eliminated are not largely adopted which inventors of the present invention have obtained from a glass paste manufacturer, the elimination of lead from dielectric glass is technically difficult, and a manufacturing cost is pushed up. Accordingly, the glass paste manufacturer has no plan for the development of products from which lead is eliminated.

What is problematic here is the possibility that the regulation which inhibits the presence of lead in glass is suddenly executed by an international organization or the like so that the above-mentioned manufacturer who manufactures a circuit board on which circuits are formed such that a conductive pattern, resistors and dielectrics are formed on a ceramic substrate by printing and these printed components are baked cannot manufacture the above-mentioned circuit-board products.

On the other hand, with respect to a low temperature co-fired ceramics substrate (hereinafter referred to as LTCC substrate) which has been started to appear on the market in last decade, the technique which eliminates lead has made progress so that the elimination of lead is realized whereby the LTCC substrate has been attracting attention as an environmentally-friendly ceramic circuit board. However, with respect to the LTCC substrate, a high manufacturing cost is named as a task to be solved.

JP-A-2005-223226 introduces the structure where a ceramic substrate and a composite resin substrate are joined to each other. In this patent literature, a method which copes with warping generated by the difference in linear expansion coefficient between these two substrate is disclosed. JP-A-2007-208243 discloses the structure where a metal pad layer is formed on a floor surface of an LTCC substrate for mounting the LTCC substrate on an additional external circuit board, and the LTCC substrate and the external circuit board are joined to each other by soldering. Further, JP-A-2006-124201 discloses constitutional materials of a green sheet for forming an LTCC substrate where lead is eliminated from the green sheet.

### Citation List

### Patent Literature

PTL 1: JP-A-2005-223226
PTL 2: JP-A-2007-208243
PTL 3: JP-A-2006-124201

### Summary of Invention

### Technical Problem

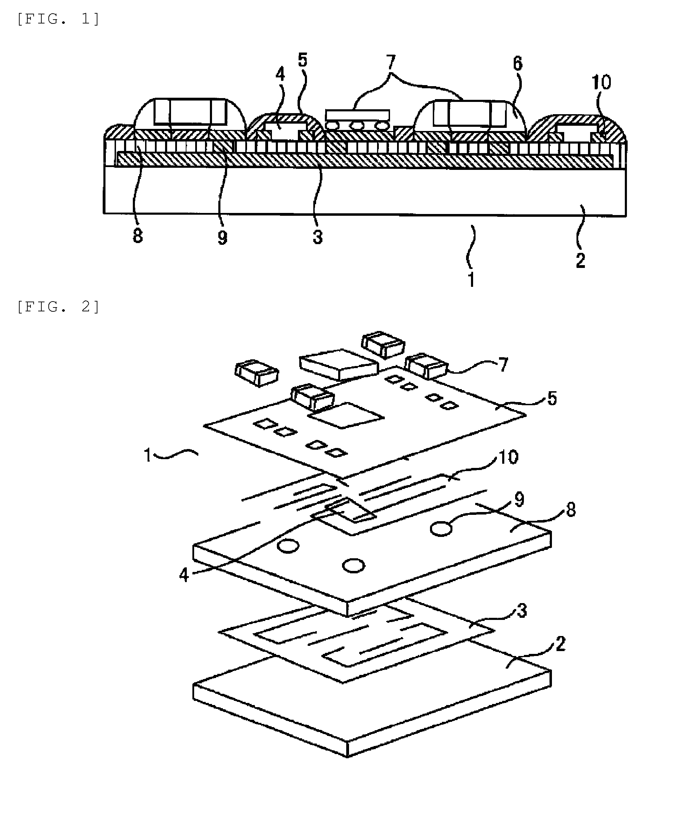

Firstly, a ceramic circuit board is explained in conjunction with Fig. 1 to Fig. 4. An electronic circuit board is roughly classified into a ceramic-based circuit board and a printed circuit board.

A circuit board used in general has the constitution where a circuit pattern made of conductive metal is formed on a surface of a substrate material made of an insulation material. Resistors necessary for forming the circuit are formed by printing, or metal lands on which capacitors, IC chips and the like are mounted as chip parts by soldering are formed. A protective film which protects these parts from moisture and a corrosive gas is formed on these parts. The chip parts and the IC chips are mounted using solder or a conductive adhesive agent. The printed circuit board has the substantially same structure as the circuit board used in general.

The classification and the structure of the ceramic circuit board of the prior art are explained hereinafter.

Fig. 1 is a view showing the cross-sectional structure of a ceramic circuit board 1. On a surface of a plate-shaped alumina substrate 2 which is a baked body made of an insulation material such as alumina, a conductive paste formed of powder of silver, copper, an alloy of silver and palladium or the like, a glass component and a solvent is placed on a printing mask on which a circuit pattern is formed, the printing mask is brought into pressure contact with the alumina substrate 2 directly, and a circuit pattern 3 is formed on a surface of the ceramic substrate 2 using a squeegee. Thereafter, by baking the alumina substrate 2, the solvent contained in the paste is evaporated so that the printed circuit pattern 3 is fixedly mounted on the alumina substrate 2, and the glass component chemically reacts with impurities (flux) contained in the alumina substrate so that the alumina substrate 2 and the circuit pattern 3 made of the metal conductive material are adhered to each other. In the same manner, resistors 4 are also formed by printing a resistor paste in which a glass component and solvent are mixed besides ruthenium oxide which constitutes a resistor material using a printing mask. Further, a protective film 5 is also formed in the same manner by printing a glass paste or a resin paste using a printing mask. Then, a solder paste 6 is printed on predetermined portions using a printing mask and, further, electronic parts 7 such as chip parts and IC chips are mounted on the alumina substrate 2 or a conductive adhesive agent is applied to electronic parts by coating and, thereafter, the solder paste 6 is cured.

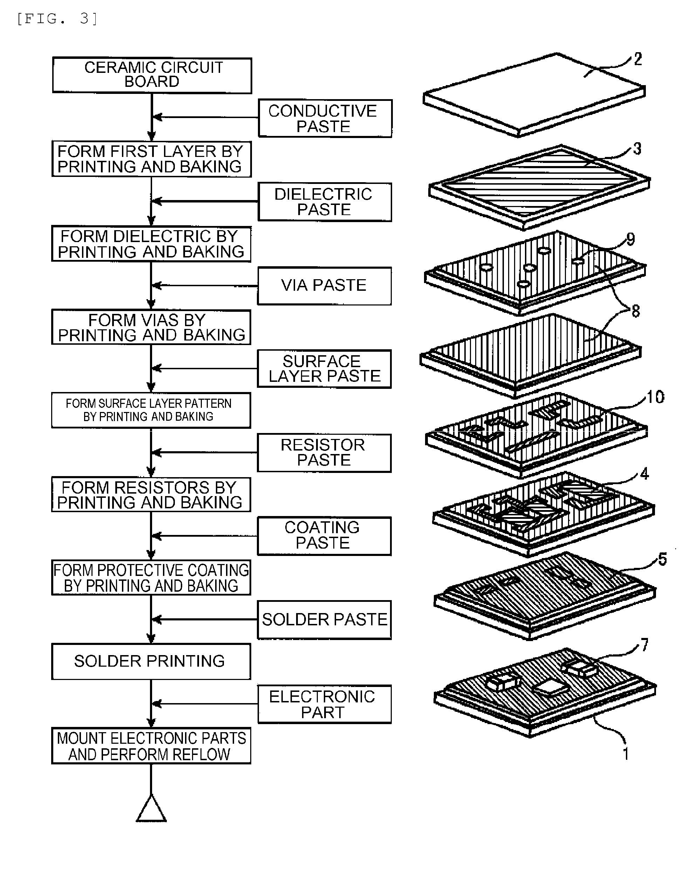

Next, a printed multi-layered circuit board in the form of a ceramic circuit board is explained in conjunction with Fig. 2 and Fig. 3. Although the printed multi-layered circuit board having two layers is explained in this embodiment, the multi-layered structure may be formed in three or more layers. The circuit pattern 3 which forms a first layer is formed on a surface of the alumina substrate 2, wherein the circuit pattern 3 is formed by printing a conductive paste which contains conductive metal, particularly conductive paste which contains silver, copper or an alloy of silver and palladium as a main component, and the printed circuit pattern 3 is baked. Next, a dielectric layer 8 is formed by printing a dielectric paste (lead glass being often used in general) plural times until a predetermined film thickness is obtained, and the printed dielectric paste is baked. Here, via holes 9 which connect the circuit pattern 3 constituting the first layer and a conductive material pattern which is formed on a surface of the dielectric 8 and constitutes a second layer are formed in a printing pattern of the dielectric 8. In the dielectric 8 in which the via holes 9 are formed, the via holes 9 are filled with a conductive metal paste substantially equal to the conductive paste used for forming the circuit pattern 3 which constitutes the first layer by printing, and the filled conductive paste is baked. Further, on a surface of the dielectric 8 where the via holes 9 are filled with the conductive paste, a wiring pattern 10 of the second layer which forms a front layer circuit pattern is formed by printing a conductive paste in the same manner as the conductive paste used for forming the circuit pattern which constitutes the first layer, and the printed wiring pattern 10 is baked. Thereby, the ceramic circuit board is completed. Thereafter, in the same manner as the above-mentioned ceramic circuit board, the resistors 4 are formed by printing a resistor paste, and the printed resistors are baked. Further, the protective film 5 is also formed by printing glass or a resin, and is baked or cured. Then, solder 6 is printed on land portions which constitute opening portions on which the electronic circuit parts 7 are mounted and the solder 6 is reflown after the electronic parts 7 such as chip parts and IC chips are mounted on the land portions thus completing the printed multi-layered ceramic circuit board 1.

The largest feature of the printed multi-layered ceramic circuit board 1 lies in that a circuit wiring pattern can be formed by printing and hence, the structure is simple whereby a highly reliable circuit board can be manufactured at a low cost. However, high-density mounting is limited. Further, the number of laminated layers is three or less in an actual use and hence, when the capacity of the circuit is increased, a circuit area is increased so that a size of the circuit board is increased.

Next, the LTCC circuit board is explained. As described previously, the LTCC circuit board is a low temperature co-fired ceramics circuit board, and the largest feature of the LTCC circuit board lies in that a circuit pattern can be formed freely on a green sheet in a state before baking ceramics, the circuit pattern is formed in multiple layers, and the green sheet and a conductive paste which forms a circuit pattern are simultaneously formed by baking thus forming a high-density circuit board. However, a fact that mechanical strength of the LTCC circuit board is lower than mechanical strength of a conventional alumina substrate, and a fact that a manufacturing cost of the LTCC circuit board is higher than a manufacturing cost of the conventional alumina substrate are named as tasks to be solved.

However, the LTCC circuit board has been developed on the premise that a glass material from which lead is eliminated is used from the beginning of the development and hence, in almost all LTCC green sheets 11 which are available on the market, a material design using a glass material from which lead is eliminated is named, and such a glass material is an environmentally-friendly material. Recently, the LTCC circuit board is used as an electronic circuit board for a mobile phone or an automobile to satisfy demands for the increase of the packing density of the circuit constitution and the miniaturization of the circuit board.

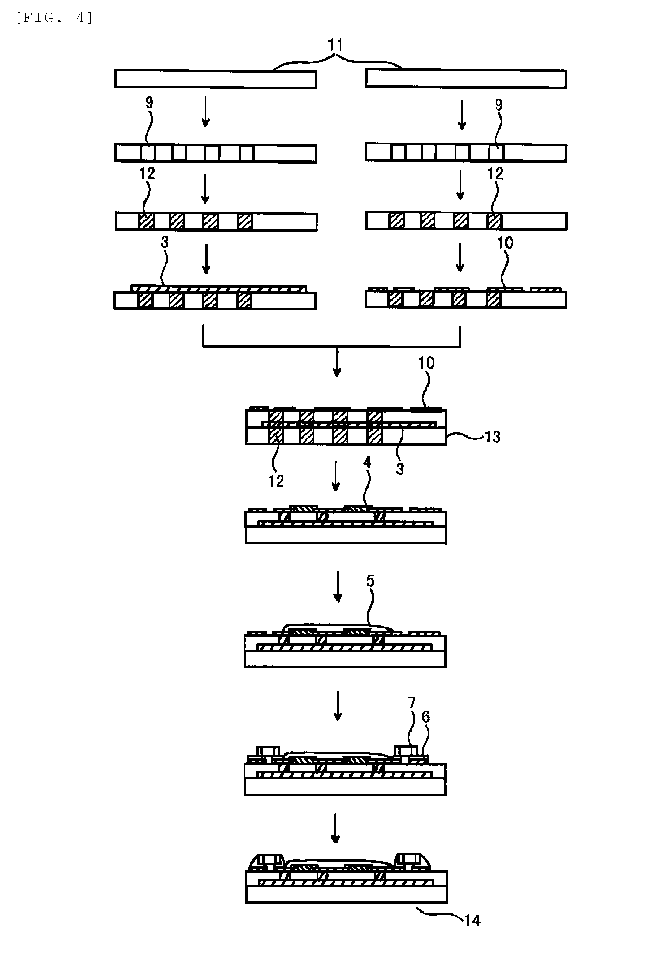

Steps of manufacturing the LTCC circuit board are explained in conjunction with Fig. 4.

The LTCC green sheet 11 is a green sheet formed by mixing alumina powder and glass powder using a solvent. The feature of the LTCC green sheet 11 lies in that almost all LTCC green sheets 11 are formed of glass from which lead is eliminated so that the LTCC green sheets 11 are brought about as the result of the progress of an environmentally friendly technique. In the LTCC green sheet 11, via holes 9 for making circuits conductive with each other are formed by a mechanical punching machine or a laser working machine. Next, the via holes 9 are filled with a conductive paste 12 which contains silver, copper or an alloy of silver and palladium as a main component by printing. Then, circuit patterns 3, 10 which are designed for respective layers are formed by a conductive paste which contains silver, copper or an alloy of silver and palladium as a main component by printing and, thereafter, the respective LTCC green sheets 11 are laminated and adhered to each other by pressing 13. Thereafter, the LTCC green sheets 11 which are adhered to each other by pressing are baked, and the LTCC green sheets 11 and the conductive paste 12 are simultaneously baked thus forming a high-density circuit board. On a surface of the LTCC circuit board, in the same manner as the above-mentioned ceramic circuit board 1, resistors 4 are formed by printing a resistor paste, and are baked. Further, the protective film 5 is also formed by printing glass or a resin, and is baked or cured. Then, solder 6 is printed on land portions which form opening portions on which electronic circuit parts 7 are mounted, and the solder 6 is reflown after the electronic parts 7 such as chip parts and IC chips are mounted thus completing a LTCC circuit board 14.

To explain the features of the ceramic circuit board 1 and the LTCC circuit board 14, in the ceramic circuit board 1, the elimination of lead from a printing paste for forming the dielectric 8 is difficult so that the ceramic circuit board 1 is slow in progress in terms of environmental friendliness. On the other hand, in the LTCC circuit board 14, the LTCC green sheet 11 from which lead is eliminated has been developed so that the LTCC circuit board 14 is a ceramic circuit board which is environmentally friendly.

Accordingly, it is an object of the present invention to form a ceramic circuit board which is not only friendly to the environment but also can be manufactured at a low cost and can exhibit high reliability by uniting a technique which can form a circuit board at a low cost with favorable productivity which are advantages of the ceramic circuit board 1 and a technique which the LTCC circuit board 14 possesses, that is, an environmentally-friendly technique which the LTCC green sheet 11 from which lead is eliminated possesses.

### Solution to Problem

The above-mentioned drawback can be overcome by substituting a dielectric layer used in a ceramic circuit board where the development of a technique for eliminating lead from a dielectric paste is slow although the ceramic circuit board can be manufactured at a low cost with a LTCC green sheet from which lead is eliminated which is available on the market as a result of a progress in a technique for eliminating lead.

Although the above-mentioned solution to problem is described in a simplified manner, particular techniques which support the solution to problem are explained in embodiments.

### Advantageous Effects of Invention

The present invention can expect an advantageous effect that it is possible to provide an electronic circuit board which can reduce a manufacturing cost through the enhancement of productivity while eliminating lead by uniting the advantage of the ceramic circuit board where the elimination of lead from a constitutional material is difficult although the ceramic circuit board can be manufactured at a low cost, and a technique of the LTCC circuit board where the elimination of a lead material has progressed although the circuit board is manufactured at a high cost.

### Brief Description of Drawings

[Fig. 1] Fig. 1 is a cross-sectional structural view of a conventional ceramic circuit board.
[Fig. 2] Fig. 2 is a constitutional view of members of the conventional ceramic circuit board.
[Fig. 3] Fig. 3 is a flowchart for manufacturing the conventional ceramic circuit board.
[Fig. 4] Fig. 4 is a flowchart for manufacturing a conventional LTCC circuit board.
[Fig. 5] Fig. 5 is a flowchart for manufacturing a ceramic circuit board according to the present invention.
[Fig. 6] Fig. 6 is a view showing a measure for preventing the peeling-off of a LTCC circuit board according to the present invention.
[Fig. 7] Fig. 7 is a view showing a measure for preventing the peeling-off of the LTCC circuit board according to the present invention.
[Fig. 8] Fig. 8 is a flowchart for manufacturing a ceramic circuit board according to another embodiment of the present invention.

### Description of Embodiments

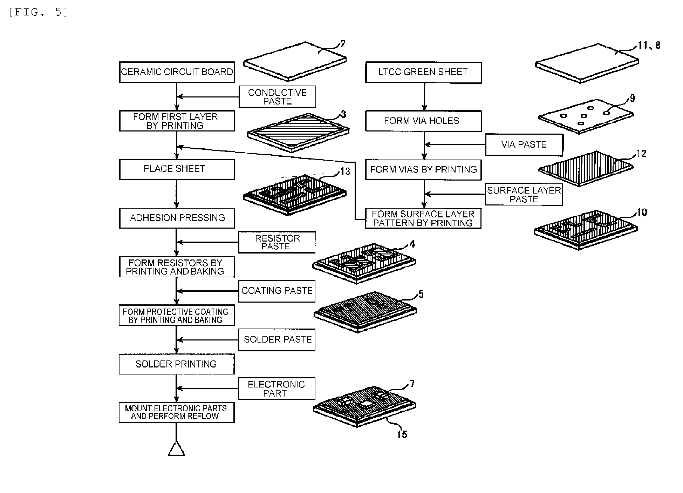

Hereinafter, embodiments of the present invention are explained in conjunction with Fig. 5 to Fig. 8.

Firstly, a first embodiment of the present invention is explained in conjunction with Fig. 5 to Fig. 7.

Fig. 5 is a view showing a manufacturing process of a ceramic circuit board 15 according to the present invention.

An LTCC green sheet 11 is manufactured in accordance with steps equal to steps for manufacturing a usual LTCC circuit board 14. Via holes 9 which electrically connect circuit patterns on upper and lower layers by establishing electrical conduction between the circuit patterns are formed in the LTCC green sheet 11. The via holes 9 are filled with a conductive paste 12 which contains silver, copper or an alloy of silver and palladium or the like as a main component by printing. Then, on a surface layer of the LTCC green sheet 11, a wiring pattern 10 which constitutes a second layer having a predetermined design is formed by printing the conductive paste 12 which contains silver, copper or an alloy of silver and palladium or the like as a main component. In this step, working of the LTCC green sheet 11 is stopped temporarily.

On the other hand, with respect to an alumina substrate 2, a circuit pattern 3 which constitutes a first layer is formed on a surface of the alumina substrate 2 by printing conductive metal, particularly a conductive paste which contains silver, copper or an alloy of silver and palladium as a main component. Thereafter, the LTCC green sheet 11 where working of the LTCC green sheet 11 is temporarily stopped previously is laminated to the alumina substrate 2 while aligning the LTCC green sheet 11 and the alumina substrate 2 with each other (the lamination being indicated by numeral 13), and compression pressing 13 is performed such that the LTCC green sheet 11 and the alumina substrate 2 are adhered to each other. Then, the LTCC green sheet 11 and the alumina substrate 2 are introduced into a baking furnace. In the baking furnace, an LTCC circuit board technique is used in such a manner that the LTCC green sheet 11, the conductive material which is formed of the conductive paste 12 and is filled in the via holes, the circuit pattern 3 which constitutes the first layer, and a wiring pattern 10 which is formed as a surface-layer conductive material are simultaneously baked. Accordingly, the alumina substrate 2, the LTCC green sheet 11, the conductive material which is formed of the conductive paste 12 and is filled in the via holes, the circuit pattern 3 which constitutes the first layer, and the wiring pattern 10 which is formed as the surface-layer conductive material are formed into an integral body (united) . The manufacture of the conventional ceramic circuit board 1 and the manufacture of the LTCC circuit board 14 take the same subsequent steps thereafter. That is, resistors 4 are formed by printing a resistor paste, and are baked. Further, a protective film 5 is also formed by printing glass or a resin, and is baked or cured. Then, solder 6 is printed on land portions which constitutes opening portions on which electronic circuit parts 7 are mounted, and the solder 6 is reflown after the electronic parts 7 such as chip parts and IC chips are mounted thus completing the ceramic circuit board 15 of the present invention.

Although the case where the number of LTCC green sheets 11 is only one (one layer) has been explained in this embodiment, the number of LTCC green sheets 11 may be two or more corresponding to the reason peculiar to the product (for example, the increase of a thickness of the circuit board necessary for increasing strength of the circuit board or the like).

The technical essence for achieving the structure of the present invention is explained hereinafter.

When the alumina substrate 2 and the LTCC green sheet 11 are baked after the circuit pattern 3 is formed on the surface of the alumina substrate 2 and the LTCC green sheet 11 is laminated to the alumina substrate 2, there occurs a phenomenon where an edge portion of the LTCC circuit board is peeled off. One of causes of such a phenomenon is that while a linear expansion coefficient of the alumina substrate 2 is 6.9 to 7.2ppm/°C, a linear expansion coefficient of silver used for forming the circuit pattern 3 which constitutes the first layer with which the LTCC circuit board is brought into contact is approximately 13 to 15ppm/°C, and a linear expansion coefficient of a dielectric 8 formed on the LTCC circuit board which is laminated to a surface of the circuit pattern 3 which constitutes the first layer formed on the surface of the alumina substrate 2 is 5 to 6ppm/°C so that an imbalance in linear expansion coefficient exists. However, the largest cause lies in the difference in shrinkage or shrinkage behavior among the respective materials when the conductive paste which is used for forming the circuit pattern 3 which constitutes the first layer and the LTCC green sheet 11 which constitutes the dielectric 8 covering the first layer are simultaneously baked. The main component of the conductive paste used for forming the circuit pattern 3 which constitutes the first layer is silver, copper, or an alloy of silver and palladium. On the other hand, the LTCC green sheet 11 is formed by mixing alumina powder, glass powder and a solvent with each other as described above. Accordingly, when both the conductive paste and the LTCC green sheet 11 are simultaneously baked, while volumes of the conductive paste and the LTCC green sheet 11 are shrunken, the conductive paste and the LTCC green sheet 11 are completely different in a shrinkage start temperature and a shrinkage ratio and hence, the above-mentioned peeling off of the edge portion of the LTCC circuit board occurs at the time of baking. To be more specific, in a case where the shrinkage behaviors of the conductive paste used for forming the circuit pattern 3 and the LTCC green sheet 11 are confirmed, the behavior where the shrinkage of the conductive paste used for forming the circuit pattern 3 starts earlier and the LTCC green sheet 11 is sintered after sintering of the conductive paste is confirmed. Accordingly, it is found that the edge portion of the LTCC circuit board is peeled off due to the reason that the conductive paste is shrunken earlier than the LTCC circuit board so that a stress at the time of shrinkage acts on the edge portion of the ELCC circuit board which constitutes a free end.

In view of the above, when the LTCC green sheet 11 is laminated to the alumina substrate 2 and is baked, the peeling-off of the edge portion of the LTCC green sheet 11 does not occur. On the other hand, after the LTCC green sheet 11 is baked in a state where the conductive paste is printed on the whole surface of the LTCC green sheet 11 in a matted manner, a state where the LTCC green sheet 11 is warped in a recessed shape occurs.

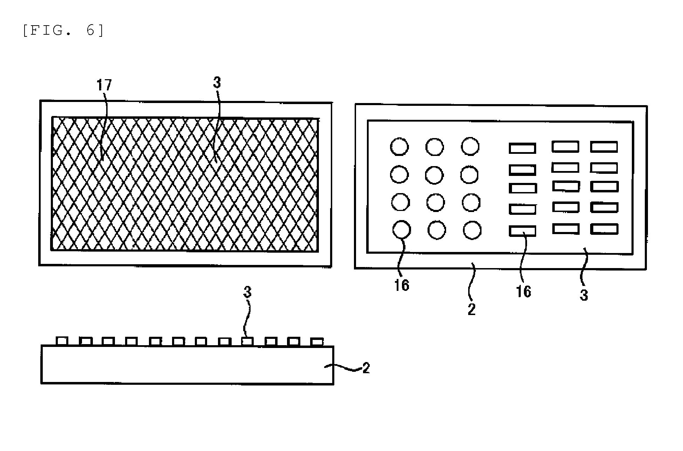

Accordingly, in the present invention, as shown in Fig. 6, circular or slit-like openings 16 are formed in a matted conductive material which is the circuit pattern 3 formed by a conductive paste constituting the first layer formed on the surface of the alumina substrate 2, and thereby portions through which the alumina substrate 2 is exposed are formed in the matted conductive material. Due to such a constitution, while ensuring an area where the alumina substrate 2 and the LTCC green sheet 11 are directly adhered to each other at a fixed level or more, the peeling-off of the edge portion of the LTCC circuit board can be suppressed whereby an effect which a stress at the time of shrinkage acts on the edge portion of the LTCC circuit board can be reduced. The largest peeling-off preventing effect can be confirmed when the circuit pattern 3 which constitutes the first layer has a meshed or grid-shaped pattern 17.

Due to the above-mentioned constitution, the ceramic circuit board 15 of the present invention which has the stable quality can be formed.

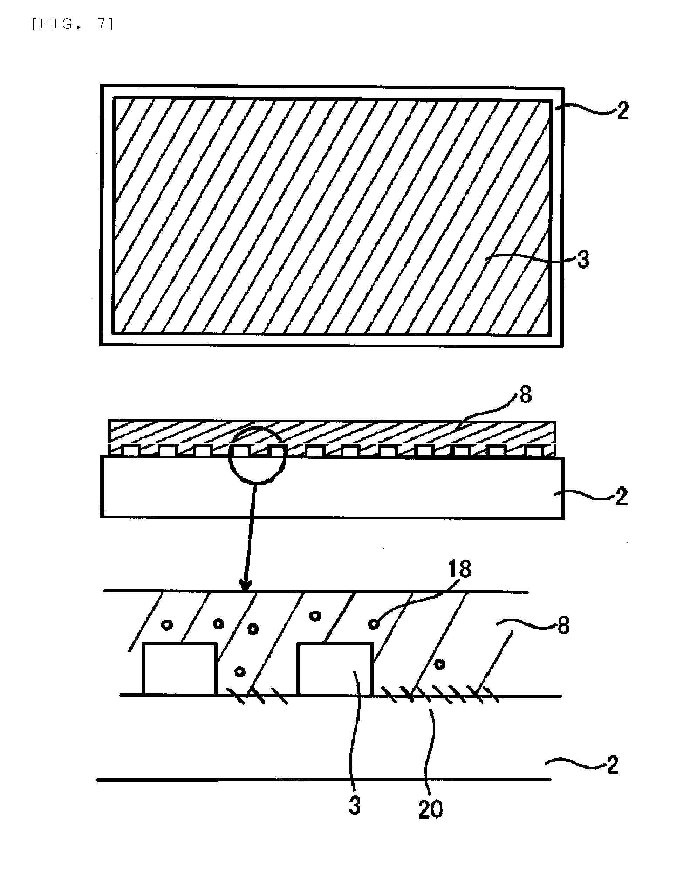

Further, the ceramic circuit board 15 of the present invention which has the stable quality can be formed by also taking a countermeasure from a viewpoint of a material. The measure is explained hereinafter in conjunction with Fig. 7.

As described above, the circuit pattern 3 which constitutes the first layer is formed on the alumina substrate 2, and the LTCC green sheet 11 which constitutes the dielectric 8 is laminated to the alumina substrate 2. In such a structure, assuming that the adhesiveness between the LTCC green sheet 11 and the alumina substrate 2, that is, the adhesive strength generated by an interaction between the LTCC green sheet 11 and the alumina substrate 2 is larger than a shrinkage stress which is generated at the time of baking the circuit pattern 3 which forms the first layer, the circuit pattern 3 which constitutes the first layer is confined by the alumina substrate 2 and the LTCC green sheet 11 so that the occurrence of the peeling-off after baking the LTCC green sheet 11 is prevented.

That is, as a method for strengthening the adhesiveness between the LTCC green sheet 11 and the alumina substrate 2, metal oxide 18 is added to the LTCC green sheet 11. As a mechanism where a conductive paste is adhered to an alumina substrate after the alumina substrate and a conductive paste made of silver or the like are baked, there has been known that when a metal material is mixed with the conductive paste, due to a reduction reaction at the time of baking, on an interface between the conductive paste and the alumina substrate, the conductive paste causes a chemical reaction with impurities (flux) of the alumina substrate so that strong chemical bonding is formed. This chemical bonding is referred to as chemical bond 20.

According to the present invention, to impart a chemical-bond-20 function for adhering the conductive paste for forming the circuit pattern 3 to the alumina substrate, 5% or less of metal oxide 18 which becomes a nucleus of the chemical bond 20 is mixed into the LTCC green sheet 11 thus imparting the chemical bond function to bonding of an interface between the LTCC green sheet 11 and an interface of the alumina substrate 2. Although a mixing amount of metal oxide is set to 0.1%, 1%, 5% and 10%, when the mixing amount is 10%, the metal oxide reacts with glass powder of the LTCC green sheet 11 so that voids are generated in the LTCC circuit board, or a linear expansion coefficient is changed due to the presence of metal oxide thus giving rise to a phenomenon where a center portion of the LTCC circuit board swells. Accordingly, it is preferable to set a mixing amount to 5% or less.

Further, the specific metal oxide 18 may be copper oxide or cuprous oxide. However, the advantageous effect of the present invention can be also acquired by using zinc oxide, nickel oxide, bismuth oxide, silver oxide, boron oxide or the like as the metal oxide 18.

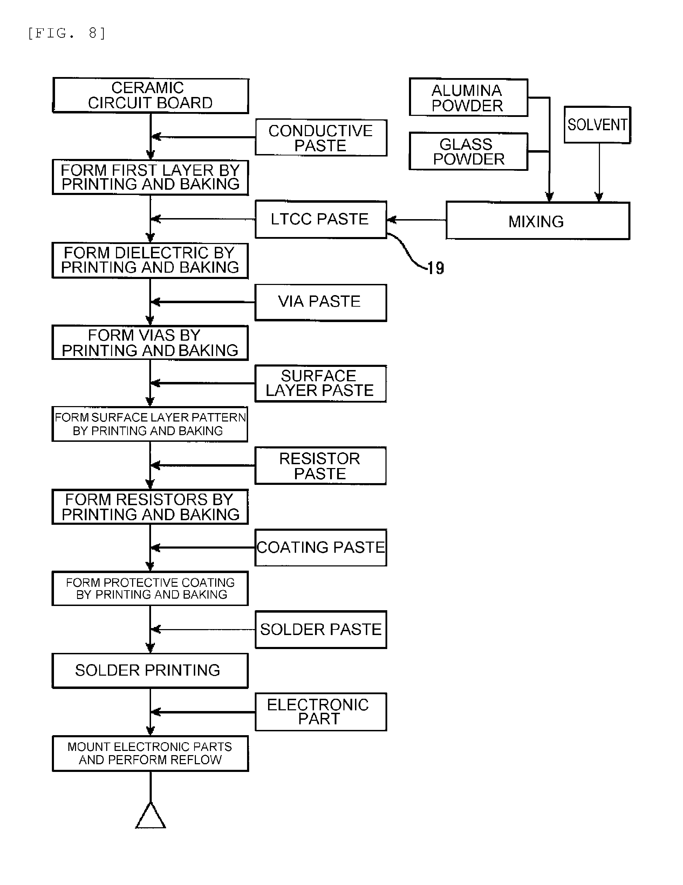

Next, a second embodiment of the present invention is explained in conjunction with Fig. 8.

In the first embodiment, the LTCC green sheet 11 from which lead can be eliminated is used in place of the printing multi-layered dielectric paste from which it is difficult to eliminate lead. As another embodiment, there is provided a measure where the LTCC green sheet 11 is used in a paste state as a printing paste. In a method of manufacturing the LTCC green sheet 11, the green sheet is formed by mixing alumina powder and glass powder with a solvent and hence, the LTCC green sheet can be used as a substitute for the printing paste by adjusting an addition amount of the solvent.

The circuit pattern 3 which constitutes a first layer is formed on a surface of the alumina substrate 2 by printing conductive metal, particularly a conductive paste which contains silver, copper or an alloy of silver and palladium as a main component. Then, the dielectric 8 is formed by printing an LTCC paste which is prepared by mixing alumina powder and glass powder which become raw materials of the LTCC green sheet 11 with a solvent in a paste state plural times until a predetermined film thickness is obtained and by baking printed LTCC paste. Here, the via holes 9 which connect the circuit pattern 3 constituting the first layer and the wiring pattern 10 which is formed on a surface of the dielectric 8 and constitutes the second layer to each other are formed in a pattern of the dielectric 8. Next, in the dielectric 8 in which the via holes 9 are formed, the via holes 9 are filled with a conductive metal paste substantially equal to the conductive metal paste used for forming the circuit pattern 3 which constitutes the first layer by printing, and the filled conductive metal paste is baked. Further, on a surface of the dielectric 8 where the via holes 9 are filled with the conductive paste, the wiring pattern 10 of the second layer which forms the front layer wiring pattern 10 is formed by printing a conductive paste in the same manner as the conductive paste used for forming the circuit pattern 3 which constitutes the first layer, and the printed wiring pattern 10 is baked. Thereafter, in the same manner as the above-mentioned ceramic circuit board 15, the resistors 4 are formed by printing a resistor paste, and are baked. Further, the protective film 5 is also formed by printing glass or a resin, and is baked or cured. Then, the solder 6 is printed on land portions which constitute opening portions on which the electronic circuit parts 7 are mounted, and the solder 6 is reflown after the electronic parts 7 such as chip parts and IC chips are mounted thus completing the ceramic circuit board 15 of the present invention.

According to this embodiment, the ceramic circuit board 15 can be formed without requiring an LTCC dedicated facility. A special facility is unnecessary provided that a printing machine and baking furnace are available and hence, a dielectric layer from which lead is eliminated can be easily formed at a low cost whereby it is possible to manufacture an environmentally-friendly ceramic circuit board.

As a product example which uses the ceramic circuit board 15 according to the present invention, an electronic circuit for an automobile is preferably named. A multilayered ceramic circuit board from which lead is eliminated can be developed in an air flow rate meter, temperature sensors at respective parts, a pressure sensor, an engine control unit, a humidity sensor, a temperature sensor and a pressure sensor of an exhaust system, and a miniaturized power module. It is possible to provide a highly reliable ceramic circuit board which can withstand a harsh environment while taking into account the environment as a highly reliable ceramic circuit board also having mechanical strength comparable to mechanical strength of a conventional ceramic circuit board.

### Reference Signs List

| | |
|---|---|
| 1: | ceramic circuit board |
| 2: | alumina substrate |
| 3: | circuit pattern |
| 4: | resistor |
| 5: | protective film |
| 6: | solder |
| 7: | electronic part |
| 8: | dielectric |
| 9: | via hole |
| 10: | wiring pattern |
| 11: | LTCC green sheet |
| 12: | conductive paste |
| 13: | laminating and press bonding step |
| 14: | LTCC circuit board |
| 15: | ceramic circuit board of the present invention |
| 16: | circular or slit-like cutout portion |
| 17: | meshed or grid-shaped cutout portion |
| 18: | metal oxide |
| 19: | LTCC paste |
| 20: | chemical bond |

## Claims

1. A multi-layered ceramic circuit board comprising: a sintered ceramic base body; a first circuit wiring pattern which is formed on a surface of the ceramic base body and is formed of conductive paste made of conductive metal; an insulation layer which is formed on a surface layer of the first circuit wiring pattern and is made of a dielectric; and a conductive pattern and a resistor which are formed on a surface layer of the insulation layer, the conductive pattern having a second circuit wiring pattern and a land on which a circuit mounting part is formed, wherein the portions other than the land portion on which the circuit mounting part is mounted are covered with a protective film by coating, and an electronic circuit part is connected to the land by a conductive adhesive agent, wherein
the dielectric is formed of a green sheet of a low temperature co-fired ceramics circuit board which is prepared by mixing alumina powder and glass powder with a solvent.

2. A multi-layered ceramic circuit board comprising: a sintered ceramic base body; a circuit wiring pattern which is formed by printing a conductive material made of conductive metal on a surface of the ceramic base body; and a green sheet of a low temperature co-fired ceramics circuit board in which a through hole which constitutes a via conductive material is formed, the green sheet being prepared by mixing alumina powder and glass powder with a solvent, wherein
the through hole formed in the green sheet is filled with a conductive paste,
a circuit pattern is formed by printing a conductive paste on a surface layer of the green sheet of the low temperature co-fired ceramics circuit board,
the green sheet of the low temperature co-fired ceramics circuit board is laminated to the ceramic base body in multiple layers,
a conductive pattern on which a circuit wiring pattern and a land on which a circuit mounting part is formed are formed and a resistor are formed on an uppermost layer of the green sheets of low temperature co-fired ceramics circuit boards laminated in multiple layers,
the portions other than the land portion on which the circuit mounting part is mounted are covered with a protective film by coating, and
an electronic circuit part is connected to the land by a conductive adhesive agent.

3. The multi-layered ceramic circuit board according to claim 1, wherein
the green sheet of the low temperature co-fired ceramics circuit board is formed of a glass powder material which contains no lead.

4. The multi-layered ceramic circuit board according to claim 1, wherein a circular or slit-like opening is formed in the first circuit wiring pattern so as to expose a portion of the ceramic base body, or the first wiring pattern is formed into a meshed shape or grid shape thus forming a wiring pattern where a partially cutout portion is formed in the first layer such that an alumina substrate which constitutes the base body and a dielectric layer which sandwiches a first layer wiring pattern formed of conductive metal with the alumina substrate are directly brought into contact with each other.

5. The multi-layered ceramic circuit board according to claim 1, wherein the first circuit wiring pattern is formed into a meshed shape or a grid shape thus exposing a portion of the ceramic base body whereby a partially cutout portion is formed such that the green sheet of the low temperature co-fired ceramics circuit board and the first circuit wiring patter are brought into direct contact with each other.

6. The multi-layered ceramic circuit board according to claim 1, wherein metal oxide is mixed into the green sheet of the low temperature co-fired ceramics circuit board.

7. The multi-layered ceramic circuit board according to claim 5, wherein
the metal oxide mixed into the green sheet of the low temperature co-fired ceramics circuit board is one selected from a group consisting of copper oxide, cuprous oxide, zinc oxide, nickel oxide, bismuth oxide, silver oxide and boron oxide.

8. The multi-layered ceramic circuit board according to claim 5, wherein a mixing rate of the metal oxide mixed into the green sheet of the low temperature co-fired ceramics circuit board is 5% or less.

9. A multi-layered ceramic circuit board comprising: a sintered ceramic base body; a first circuit wiring pattern which is formed on a surface of the ceramic base body and is formed of conductive paste made of conductive metal; an insulation layer which is formed on a surface layer of the first circuit wiring pattern and is made of a dielectric; and a conductive pattern and a resistor which are formed on a surface layer of the insulation layer, the conductive pattern having a second circuit wiring pattern and a land on which a circuit mounting part are formed, wherein the portions other than the land portion on which the circuit mounting part is mounted are covered with a protective film by coating, and an electronic circuit part is connected to the land by a conductive adhesive agent, wherein
the dielectric is formed of a low temperature co-fired ceramics paste which is prepared by dissolving alumina powder and glass powder into a solvent.

10. A vehicle-mounted electronic device being **characterized in that** the multi-layered ceramic circuit board according to any one of claims 1 to 8 is mounted on a sensor which is mounted in an engine room of an automobile, around an exhaust system of the automobile or an engine control unit of the automobile.
